# FASCICULE DE BREVET EUROPEEN

(11) **EP 2 066 023 B1**
(45) Date de publication et mention de la délivrance du brevet: **29.06.2011**
(21) Numéro de dépôt: 08168949.9
(22) Date de dépôt: 12.11.2008
(51) Int. Cl.: H03F 1/32

(54) **Amplificateur HF large bande comportant un système de réduction de distorsion et procédé de réduction de distorsion associé**
Breitband-HF-Verstärker, der ein Verzerrungsreduzierungssystem umfasst und entspreches Verzerrungsreduzierungsverfahren
HF broadband amplifier comprising a system for reducing distortion and associated distortion reduction method

(30) Priorité: 29.11.2007 FR 0759422
(43) Date de publication de la demande: 03.06.2009
(73) Titulaire: LPA Concepts, 33650 Martillac (FR)
(72) Inventeur: Powell, .Jack, 33140, CADAUJAC (FR); Guillemet, Olivier, 33460 Castres Gironde (FR)
(74) Mandataire: Schmit, Christian Norbert Marie

(56) Documents cités:
- EP-A- 0 991 210
- EP-A- 1 267 486
- JP-A- 2003 142 948
- US-A- 5 493 252

## Description

La présente invention concerne un amplificateur HF large bande comportant un système de réduction de distorsion de l'amplificateur sur l'ensemble de la bande d'amplification et un procédé de réduction de distorsion pour un tel amplificateur. Elle s'applique notamment pour les amplificateurs de puissance large bande d'émission radio-fréquence fonctionnant notamment dans les bandes d'émission des réseaux de téléphonie mobile.

Les amplificateurs radiofréquences de puissance qui doivent concilier un bon rendement électrique et une bonne linéarité sur une large bande sont généralement réalisés en classe AB.

Il reste que la linéarité obtenue avec un simple amplificateur de classe AB est parfois insuffisante à forte puissance pour que les produits d'intermodulation ne perturbent pas les canaux de communication voisins.

Il est connu pour réduire les produits d'intermodulation d'utiliser des techniques de pré-distorsion ou selon la méthode connue sous l'appellation feedforward selon la terminologie anglo-saxonne qui sera traduite ici par compensation d'un amplificateur par correction aval ou amplificateur à compensation aval comme pour la publication internationale WO/2005/091802 A2.

Lorsque la largeur de bande du signal est limitée, par exemple de l'ordre de 20 MHz pour un amplificateur fonctionnant dans des bandes de l'ordre de 1 à 10 GHz et lorsque la non-linéarité est simple on préférera la méthode de pré-distorsion qui est la moins coûteuse.

Lorsque la largeur de bande du signal est grande ou lorsque les non linéarités sont complexes, la technologie du feedforward doit être employée malgré sa complexité et son coût important.

Le principe de la technologie feedforward consiste à extraire les produits d'intermodulation du signal de sortie de l'amplificateur de puissance, ou amplificateur principal et, après amplification par un amplificateur d'erreur, à réinjecter ces produits d'intermodulation en opposition de phase avec le signal de sortie de l'amplificateur principal.

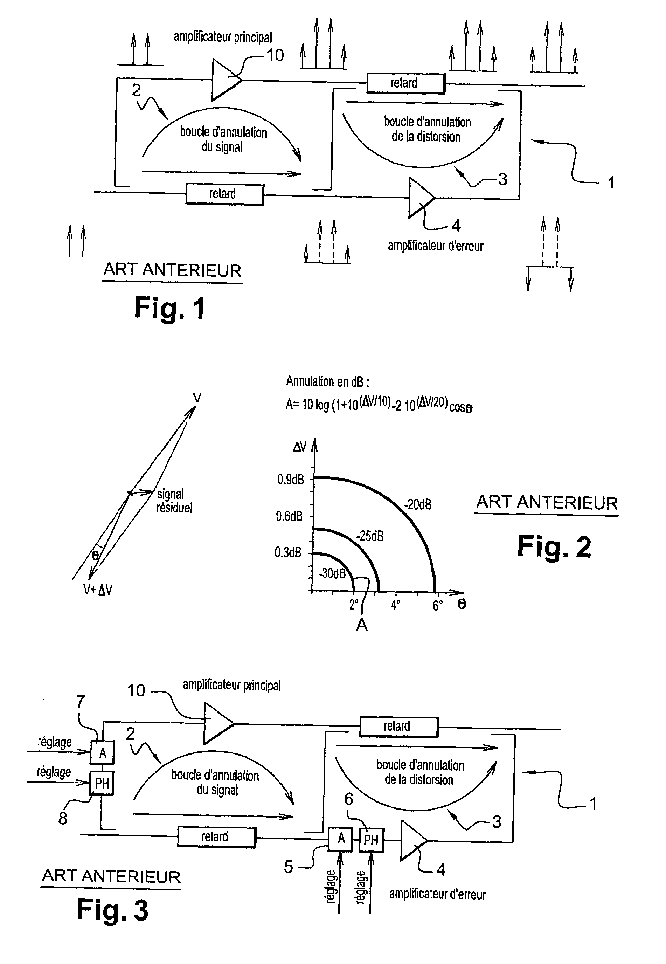

Le schéma de principe de cette technique connue est donné à la figure 1.

Selon ce principe l'amplificateur feedforward 1 comporte un amplificateur principal 10 comporte une première boucle 2 d'annulation du signal et un amplificateur d'erreur 4 reboucle une boucle d'annulation de la distorsion sur la sortie de l'amplificateur principal.

Ce principe simple dans son énoncé est toutefois complexe à mettre en oeuvre car il repose sur l'annulation exacte du signal utile dans une première boucle d'annulation du signal et sur l'annulation exacte des produits d'intermodulation dans une seconde boucle d'annulation de la distorsion.

Pour correctement annuler les signaux, il est nécessaire qu'ils soient d'amplitude très proche et qu'ils aient une différence de phase très proche de 180°.

Notamment, selon la figure 2, pour une atténuation A de 30dB, l'erreur de phase θ doit être inférieure à 2° et l'erreur d'amplitude ΔV inférieure à 0,3dB selon la formule donnant l'atténuation A=10log(1 +1 0^{(ΔV/10)} -2x10^{(ΔV/20)}cosθ).

Il est ainsi connu de faire appel à un ajustement très précis de réseaux 5, 6, 7, 8 de variation d'amplitude et de phase dans chacune des boucles comme représenté en figure 3.

Cet ajustement doit en outre être dynamique en temps réel pour obtenir une bonne annulation car un réglage fin en usine n'est pas suffisant du fait de la variation des caractéristiques de l'amplificateur dans le temps et en température notamment.

La difficulté réside dans la réalisation d'un contrôle automatique des réseaux de correction en amplitude et en phase et en particulier dans la réalisation du contrôle automatique des réseaux de correction de la seconde boucle du fait que dans cette dernière boucle un signal important est superposé à la distorsion à mesurer.

De nombreux systèmes ont été proposés mais ils sont soit très complexes et coûteux soit simplifiés mais dans ce cas insuffisamment performants sur une large bande.

Le contrôle automatique de la deuxième boucle est notamment traditionnellement basé sur l'utilisation d'un signal pilote comme décrit notamment dans le document US 5 323 119.

Le signal pilote peut être un signal de bande étroite situé en dehors de la bande utile, un signal de bande étroite balayé dans la bande utile comme dans le document US 5 307 022 ou balayé dans des parties inoccupées de la bande utile, deux signaux pilotes situés à chaque extrémité de la bande utile et légèrement en dehors de celle-ci et notamment, le document US 3 922 617 décrit un système feedforward adaptatif pour un amplificateur fonctionnant en classe C et basé sur l'utilisation de deux signaux pilotes. Le document US5493252 décrit un système similaire.

D'autres solutions utilisent un signal pilote constitué de deux bandes latérales d'une porteuse située en plein centre de la bande utile de manière à encadrer le signal utile ou utilisent un signal large bande situé dans la bande utile.

Le principe général est de détecter le pilote résiduel, après annulation dans la seconde boucle, grâce au signal de référence venant du générateur de signal pilote. Un démodulateur en quadrature permet d'extraire les composantes I est Q du pilote résiduel. Les tensions correspondant aux composantes I est Q sont appliquées sur les réseaux d'ajustement d'amplitude et de phase. En outre, la phase du signal de référence est ajustée de manière à ce que la boucle de contrôle soit une boucle à contre réaction négative à la fois sur les composantes I et Q.

Dans tous les cas, la difficulté est de détecter le pilote résiduel qui est très faible en amplitude en présence d'un signal large bande dont l'amplitude est typiquement 60dB supérieure à celle du pilote résiduel.

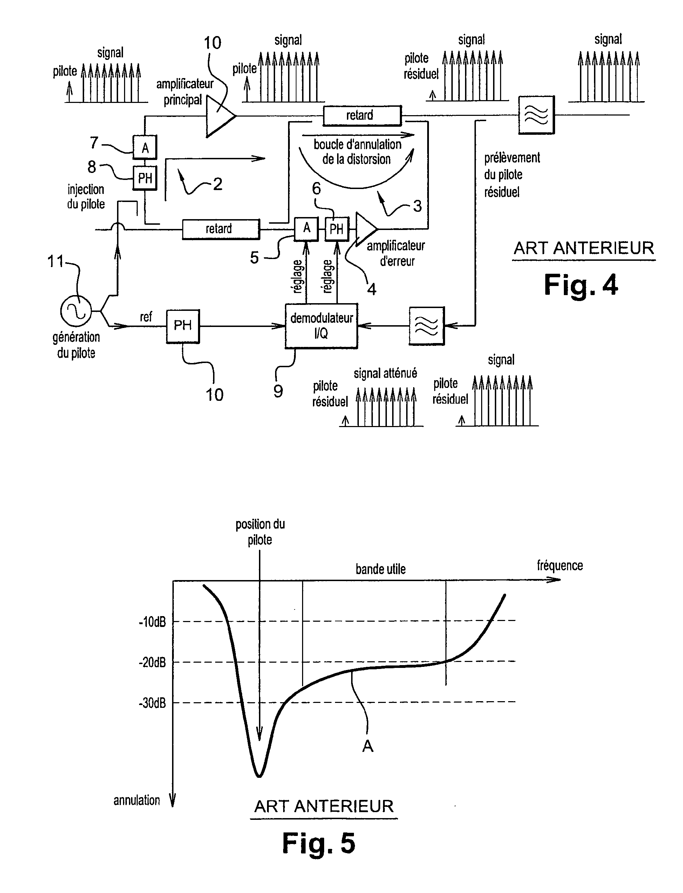

La figure 4 schématise un dispositif de l'art antérieur à simple pilote situé en dehors de la bande utile et la figure 5 une courbe d'annulation typique lors de l'utilisation d'un pilote situé au dessous de la bande utile.

Dans ce schéma, les réseaux de correction 5, 6 de la boucle d'annulation de la distorsion 3 sont commandés par un démodulateur I/Q recevant un signal pilote de référence ref déphasé par un réseau 10 et le pilote résiduel en sortie de l'amplificateur.

Dans un tel cas, le pilote est souvent placé juste au dessous de la bande utile pour que le pilote résiduel soit assez faible pour ne pas perturber le système. Le fait qu'il soit en dehors de la bande utile permet d'augmenter légèrement son niveau dans la mesure où il peut être filtre à la sortie du système.

En outre, le démodulateur peut être protégé par un filtre qui atténuera le signal du système tout en laissant passer le pilote résiduel et la dynamique du démodulateur peut ainsi être augmentée.

Le défaut d'une telle solution est que l'annulation A va se creuser à l'endroit du pilote, comme représenté à la figure 5 représentant l'annulation en dB en fonction de la fréquence et être moins efficace dans le haut de la bande utile car les amplificateurs n'ont en général pas une réponse complètement plate en amplitude et en phase.

Ceci conduit à trouver un compromis en positionnant le pilote suffisamment près de la bande utile pour que l'annulation soit bonne sur toute cette bande mais pas trop car dans ce cas, les filtrages précédemment mentionnés deviennent très difficiles à réaliser.

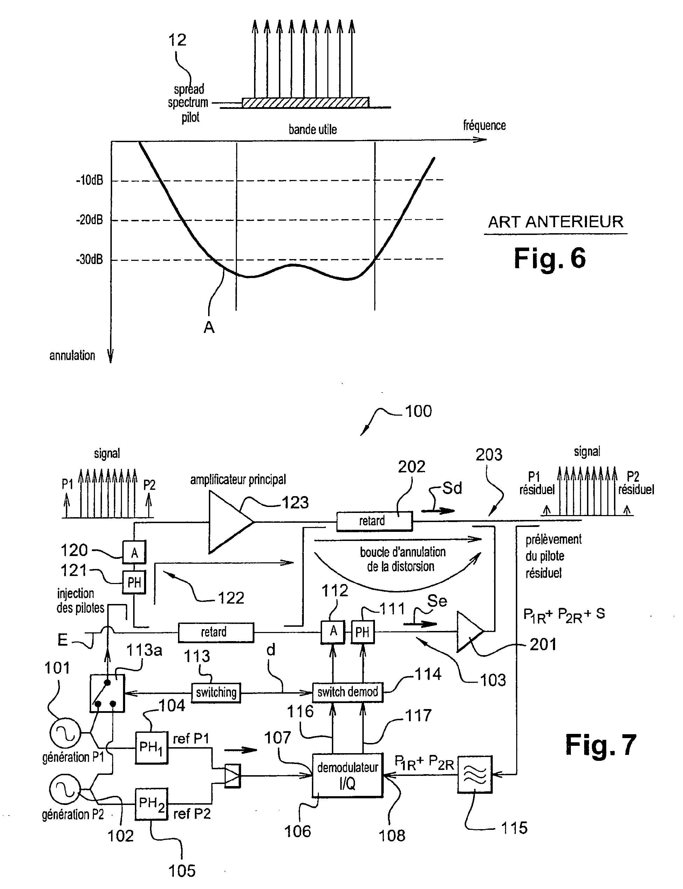

L'exemple de la figure 6 représente la courbe d'annulation A obtenue dans le cas d'un dispositif utilisant un pilote à étalement de spectre 12.

Dans ce cas, on cherche à placer le pilote dans la bande utile et même sur toute celle-ci.

La technique d'étalement de spectre permet de conserver un pilote à un niveau global de puissance suffisant pour effectuer une détection tout en gardant un niveau de pilote très bas en chaque point de fréquence.

La courbe d'annulation obtenue représentée en figure 6 dans un tel cas permet d'optimiser l'annulation A sur toute la bande utile.

Par contre, l'inconvénient de cette solution est que la contrainte dynamique sur le démodulateur est importante et qu'aucun filtrage préalable ne peut être effectué.

Il y a lieu dans ce cas de conserver un niveau de pilote élevé qui se retrouve dans toute la bande de fréquences.

Comme vu précédemment, une autre solution pour optimiser l'annulation sur toute la bande est d'utiliser deux signaux pilotes un au dessous de la bande, l'autre au dessus, que ces signaux soient deux bandes latérales d'une seule porteuse située au centre de la bande utile ou deux signaux séparés.

Dans le cas où les signaux sont deux bandes latérales d'une seule porteuse, la détection de la modulation permet de régler le réseau de phase et le réseau d'amplitude de la seconde boucle.

Dans le cas où les signaux sont deux signaux pilotes séparés et disposés à chacune des extrémités de la bande utile, il est alors possible de régler un réseau d'amplitude et un réseau de phase à réponses fréquentielles plates à l'aide du premier pilote et un réseau d'amplitude et un réseau de phase dont les réponses fréquentielles présentent une pente à l'aide du second pilote.

Une telle solution est très performante et permet une annulation sur une large bande. Par contre sa mise en oeuvre est complexe et onéreuse.

Elle nécessite notamment une duplication du générateur de signal pilote et du démodulateur et nécessite en outre la réalisation de réseaux de pente et une multiplication des réseaux qui ont pour conséquence une augmentation du délai sur la seconde boucle.

Il est connu en outre du document US 6 157 254 d'utiliser deux signaux pilotes situés à chacune des extrémités de la bande utile de l'amplificateur et de moyenner les informations de détections de ces deux signaux pilotes afin de n'utiliser qu'un seul détecteur et de ne régler qu'un seul réseau de correction d'amplitude et qu'un seul réseau de correction de phase en répartissant l'erreur entre le bas et le haut de la bande utile.

La présente invention a pour objet de réaliser un amplificateur HF large bande comportant un système de réduction de distorsion de l'amplificateur sur l'ensemble de la bande d'amplification par correction feedforward en utilisant un premier signal pilote et un second signal pilote et une boucle d'annulation comportant un dispositif de correction d'erreurs basé sur les deux signaux pilotes pour lequel le dispositif de correction d'erreurs comporte des premiers moyens de réglage d'une différence de phase proche de 180° entre le premier signal pilote et le signal résiduel de ce premier signal pilote en sortie de l'amplificateur et des seconds moyens de réglage d'une différence de phase proche de 0° entre le second signal pilote et le signal résiduel de ce second signal pilote en sortie de l'amplificateur pour alimenter au moins un démodulateur HF de pilotage de la boucle d'annulation.

Avantageusement le dispositif de correction d'erreurs comprend un unique moyen de correction de phase et un unique moyen de correction d'amplitude, dans une boucle d'annulation de distorsion de l'amplificateur.

Selon un mode de réalisation préférentiel, le dispositif de correction d'erreur comporte des moyens de commutations adaptés pour injecter alternativement les deux signaux pilotes en entrée de l'amplificateur et adaptés à générer un signal de découpage pour commander alternativement en correspondance un étage de démodulation BF commandant lesdits réseaux de correction de phase et d'amplitude.

Selon un mode de réalisation particulier, la détection HF est préférablement réalisée à l'aide d'un unique démodulateur HF, de type démodulateur HF I/Q selon l'exemple, recevant simultanément sur sa première entrée les premier et second signaux pilotes de référence et sur sa seconde entrée le signal de sortie de l'amplificateur au travers d'un filtre adapté pour laisser passer les signaux pilotes résiduels et atténuer les fréquences situées dans la bande de l'amplificateur.

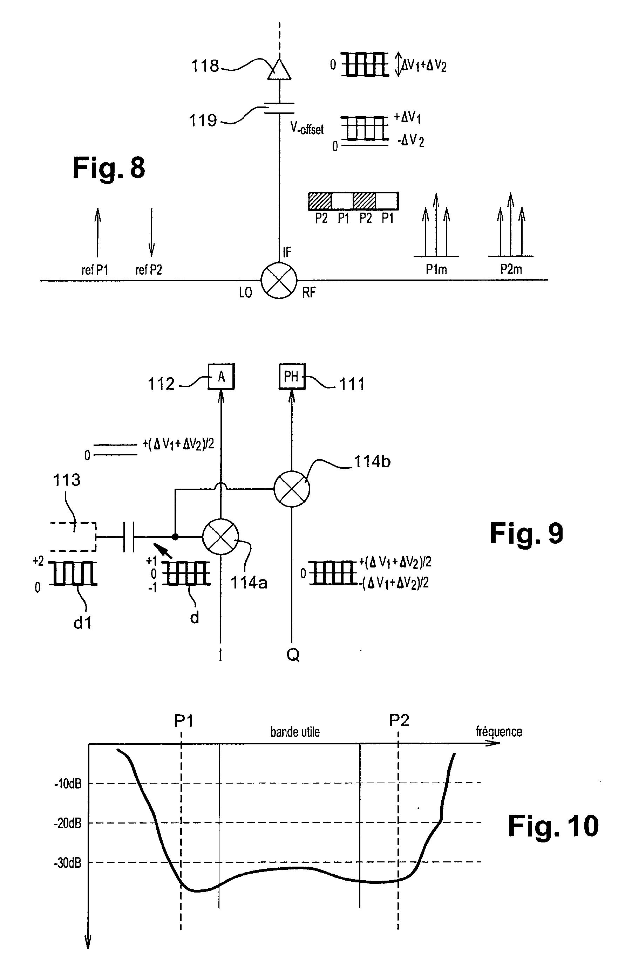

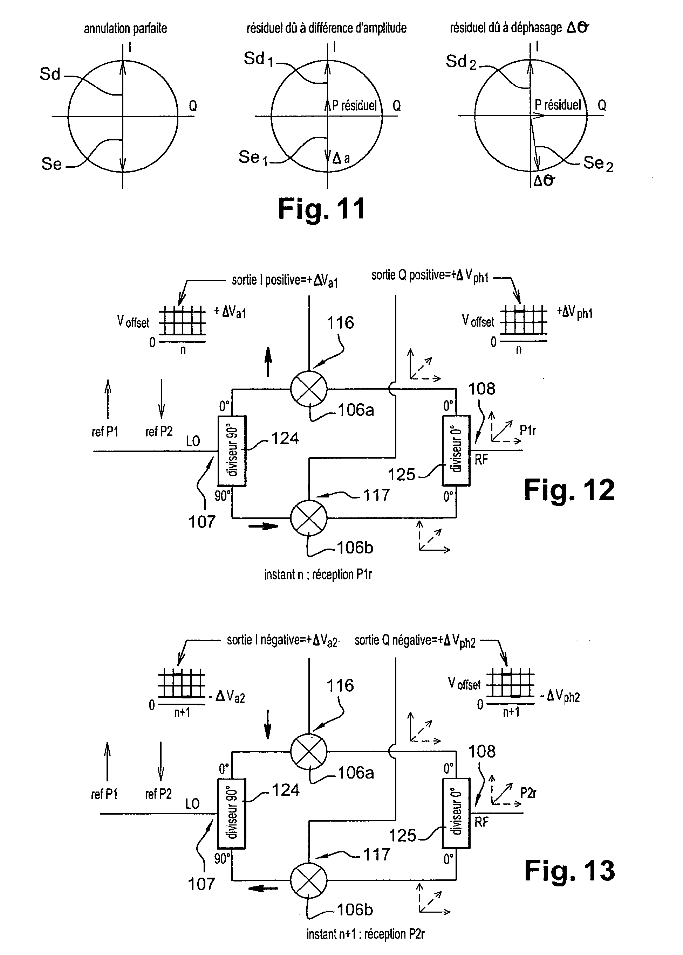

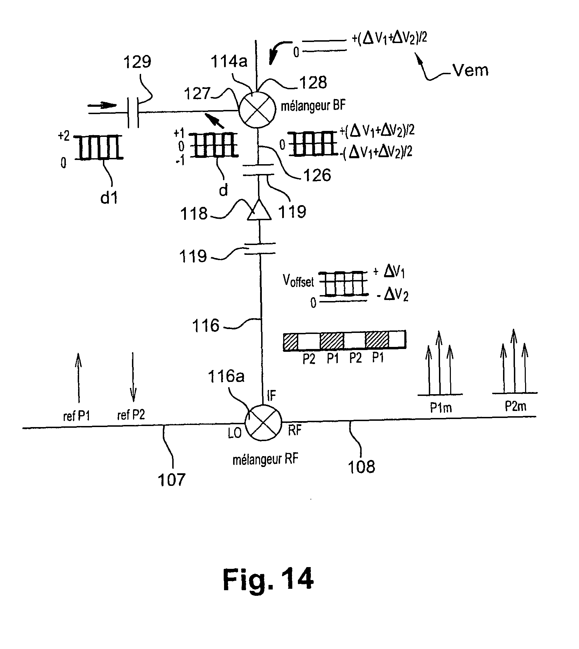

D'autres caractéristiques et avantages de l'invention seront apparents à la lecture de la description qui suit d'un exemple de réalisation non limitatif de l'invention en référence aux dessins qui représentent:
en figure 1: un schéma de principe d'un amplificateur à boucle feedforward de l'art antérieur;
en figure 2: une représentation schématique de l'annulation vectorielle de signaux selon le dispositif de la figure 1;
en figure 3: une vue du dispositif de la figure 1 représentant des moyens d'annulation d'erreur à base de réseaux de correction d'amplitude et de phase;
en figure 4: un schéma de principe d'un amplificateur de l'art antérieur utilisant un pilote à bande étroite en dessous de la bande utile de l'amplificateur;
en figure 5: un graphique représentant l'annulation obtenue avec le dispositif de la figure 4;
en figure 6: un graphique représentant l'annulation obtenue avec un dispositif de l'art antérieur comportant un pilote à étalement de spectre dans la bande utile de l'amplificateur;
en figure 7: un schéma de principe d'un amplificateur à boucle feedforward selon l'invention;
en figure 8: un schéma d'un dispositif de démodulation HF de l'amplificateur de l'invention;
en figure 9: un schéma d'un dispositif de démodulation BF de l'amplificateur de l'invention;
en figure 10: un graphique représentant l'annulation obtenue avec l'amplificateur de l'invention;
en figure 11: une représentation schématique de différents cas d'annulation parfaite et imparfaites selon les axes I et Q pour un signal pilote;
en figure 12: un schéma d'un démodulateur HF I/Q selon un exemple de réalisation de l'invention lors de la détection sur le démodulateur I/Q du pilote résiduel P1 r à l'instant n;
en figure 13: le démodulateur HF I/Q de la figure 12 lors de la détection sur le démodulateur I/Q du pilote résiduel P2r à l'instant n+1;
en figure 14: un schéma représentant un exemple de réalisation d'une voie d'étages de démodulation HF et BF de l'amplificateur de la figure 7.

L'invention prévoit un amplificateur HF large bande 100 comportant un système de réduction de distorsion de l'amplificateur sur l'ensemble de la bande d'amplification par correction feedforward représenté de manière globale à la figure 7.

L'amplificateur comprend un module d'amplification 123 disposé de manière connue dans une première boucle de compensation 122 comportant des réseaux 120, 121 de correction de phase et d'amplitude de la première boucle qui n'est pas l'objet de la présente demande.

Pour annuler ou limiter dynamiquement la distorsion et le bruit de l'amplificateur, une seconde boucle de régulation est nécessaire et la présente invention, qui concerne cette seconde boucle utilise un premier signal pilote P1 et un second signal pilote P2 et une boucle d'annulation 103 comportant un dispositif de correction d'erreurs basé sur les deux signaux pilotes.

Selon l'invention, le dispositif de correction d'erreurs comporte des premiers moyens 104 de réglage d'une différence de phase proche de 0° (éventuellement modulo 360°) entre le premier signal pilote et le signal résiduel de ce premier signal pilote en sortie de l'amplificateur et des seconds moyens 105 de réglage d'une différence de phase proche de 180° (éventuellement modulo 360°) entre le second signal pilote et le signal résiduel de ce second signal pilote en sortie de l'amplificateur pour alimenter au moins un démodulateur HF 106 de pilotage de la boucle d'annulation.

Il est à noter que la différence de phase introduite n'a pas besoin dans le cas de la présente invention d'être d'une très grande précision et une erreur de + ou - 10° est tolérable sans dégrader de façon très importante l'annulation de la distorsion qui reste même dans ce cas inférieure à la valeur de -30dB que l'on cherche à obtenir.

De cette façon il est possible de traiter simultanément les signaux résiduels P1r et P2r par rapport aux signaux pilotes injectés dans l'amplificateur et dans la boucle d'annulation dans le même démodulateur sans qu'ils n'interfèrent entre eux et de sorte que les tensions qu'il génèrent s'ajoutent en valeur absolue.

Toujours selon la figure 7, les premiers moyens 104 de réglage d'une différence de phase comportent un premier moyen déphaseur disposé entre un générateur 101 du premier signal pilote P1 et une première entrée 107 d'un démodulateur HF 106 recevant sur une seconde entrée 108 le signal résiduel P1r issu du premier signal pilote en sortie de l'amplificateur HF, le premier moyen déphaseur fournissant un premier signal pilote de référence refP1 déphasé dont le déphasage compense le déphasage depuis l'entrée de l'amplificateur jusqu'à la seconde entrée du démodulateur 106 et introduisant un déphasage supplémentaire de sorte que les 2 signaux refP1 et P1r soient en phase.

Les second moyens 105 de réglage d'une différence de phase comportent pour leur part un second moyen déphaseur disposé entre un générateur 102 du second signal pilote et une première entrée 107 d'un démodulateur HF 106 recevant sur une seconde entrée 108 le signal résiduel P2r issu du second signal pilote en sortie de l'amplificateur HF, le moyen déphaseur 105 fournissant un second signal pilote de référence refP2 déphasé dont le déphasage compense le déphasage depuis l'entrée de l'amplificateur jusqu'à la seconde entrée du démodulateur 106 et introduisant un déphasage supplémentaire de l'ordre de 180°de sorte que les deux signaux soient en opposition de phase.

Contrairement aux dispositifs de l'art antérieur à deux pilotes, la boucle d'annulation 103 de l'amplificateur selon la présente invention comprend un unique moyen de correction de phase 111 et un unique moyen de correction d'amplitude 112. Ces moyens sont selon l'exemple constitués par un réseau de correction de phase et un réseau de correction d'amplitude mais peuvent être de façon équivalente regroupés en un réseau unique de modulation I/Q réalisant un moyen de correction de phase et un moyen de correction d'amplitude.

L'amplificateur HF large bande de l'invention comporte avantageusement des moyens de commutations 113, 113a adaptés pour injecter alternativement les deux signaux pilotes en entrée de l'amplificateur et adaptés à générer un signal de découpage d pour commander alternativement en correspondance un étage de démodulation BF 114 commandant lesdits réseaux de correction de phase et d'amplitude 111, 112 de la boucle d'annulation 103.

De même, la détection HF est réalisée à l'aide d'un unique démodulateur HF 106, qui selon l'exemple est de type démodulateur HF I/Q.

Les premier et second signaux pilotes de référence refP1, refP2, dont l'un est déphasé, sont reçu sur la première entrée 107 du démodulateur HF I/Q 106, entrée LO sur la figure 8, et le signal de sortie de l'amplificateur est reçu sur la seconde entrée du démodulateur HF I/Q, entrée RF sur la figure 8, au travers d'un filtre 115 représenté à la figure 7 et adapté pour laisser passer les signaux pilotes résiduels P1r, P2r et atténuer les fréquences S situées dans la bande de l'amplificateur.

Ce filtre 115 de type coupe bande permet d'atténuer les signaux S amplifiés par l'amplificateur dans la bande utile pour améliorer la détection des signaux pilotes résiduels P1r, P2r qui sont injectés à un niveau proche du niveau de la distorsion de l'amplificateur.

Les pilotes résiduels P1r et P2r sont reçus alternativement sur l'entrée RF du mélangeur HF.

Lorsque P1r est reçu sur l'entrée RF il génère une déviation positive ΔV1 par rapport à la tension d'offset du mélangeur et lorsque P2r est reçu sur l'entrée RF du mélangeur il génère une déviation -ΔV2 par rapport à la tension d'offset du mélangeur.

L'invention permet de n'utiliser qu'un seul dispositif récepteur constitué du démodulateur HF, 106, du démodulateur BF 114 et des réseaux de correction de phase et d'amplitude 111, 112 tout en employant deux signaux pilotes ce qui ne rend pas le système beaucoup plus compliqué qu'un système à simple pilote et nettement moins compliqué qu'un système complet à deux pilotes et pour lequel l'ensemble des moyens de détection et de correction sont dupliqués.

Ainsi, l'invention permet d'utiliser deux pilotes situés à chacune des extrémités de la bande de l'amplificateur mais de n'utiliser qu'un seul détecteur et de moyenner les informations de détection des deux pilotes de manière à ne régler qu'un seul réseau d'amplitude et qu'un seul réseau de phase.

Les deux pilotes vont alors permettre d'établir un compromis entre le haut de bande et le bas de bande pour obtenir la correction représentée à la figure 10 qui atteint sans problème une correction et une réjection de la distorsion au delà de -30dB.

Avec les deux pilotes du système de réduction de la distorsion de l'invention, l'erreur résiduelle sur chaque réseau est réduite d'un facteur 2 en la répartissant entre le base de la bande et le haut de la bande.

Le réglage de la différence de phase à 180° sur les voies refP1 et refP2 permet d'utiliser les pilotes dans une configuration Push-Pull.

De retour à la figure 7, la boucle d'annulation comprend une voie directe passant par le réseau de retard 202 et une voie d'annulation passant par le moyen de correction de phase 111, le moyen de correction d'amplitude 112 et un amplificateur d'erreur 201. Ces deux voies se rejoignent au niveau du coupleur 203.

Dans la voie directe passe le signal direct Sd superposé au signal S que l'on souhaite amplifier, et dans la voie d'annulation passe le signal d'erreur Se.

Lorsque la correction est parfaite, les signaux Sd et Se sont d'amplitude égale et en opposition de phase de sorte qu'ils s'annulent au niveau du coupleur 203.

La schématisation de ces composantes résultantes est donnée à la figure 11 où de gauche à droite on a représenté un cas d'annulation parfaite pour lequel les signaux direct Sd et Signal d'erreur Se sont de même amplitude et en opposition de phase lorsque l'amplificateur est correctement compensé, un cas de compensation imparfaite en d'amplitude qui laisse une tension résiduelle Présiduel en sortie de l'amplification sur l'axe I en phase avec le signal de référence pilote, et enfin un cas d'une compensation imparfaite de l'amplificateur en phase pour laquelle la différence de phase entre les signaux Sd et Se donne une composante P résiduel en sortie d'amplification sur l'axe Q en quadrature avec le signal de référence pilote.

Sur cette figure on voit que pour des petites variations on a une équivalence entre l'amplitude et la composante I et entre la phase et la composante sur l'axe Q du fait que au premier ordre, AcosΔθ est pratiquement égal à A (cosΔθ approximativement égal à 1) et que l'angle Δθ est pratiquement égal à sinusΔθ.

Les informations d'amplitude se retrouvent sur la sortie de détection I, et les informations de phase se retrouvent sur la sortie de détection Q. Ceci permet d'attaquer indifféremment des réseaux de modulation amplitude/phase ou I/Q pour de petites variations ΔA et Δθ autour de l'annulation parfaite.

Les signaux présents sur le mélangeur ou démodulateur HF 106 sont représentés plus précisément à la figure 12 pour le traitement du signal refP1 et du signal d'erreur résultant P1r à un instant n où le démodulateur reçoit sur son entrée 108 RF le signal P1r prélevé en sortie d'amplification et, à la figure 13 à l'instant n+1 lorsque le démodulateur reçoit sur son entrée 108 le signal P2r.

Le démodulateur HF reçoit sur sa première entrée 107, entrée LO, les deux signaux refP1 et refP2 combinés, comporte après sa première entrée un diviseur 90° 124 pour attaquer des premières entrées de deux mélangeurs à FET ou mélangeurs à diodes Schottky 106a, 106b.

Le démodulateur HF reçoit alternativement sur sa seconde entrée 108, entrée R, les pilotes résiduels P1 r, P2r.

Il comporte après sa seconde entrée un diviseur 0° 124 pour attaquer des secondes entrées des deux mélangeurs à FET ou mélangeurs à diodes Schottky 106a, 106b.

Le premier mélangeur 106a recevant les signaux sans déphasage fournit sur la sortie 116 la composante de l'erreur sur l'axe I saxe direct du plan complexe et le second mélangeur 106b qui reçoit les signaux avec déphasage de 90° fournit sur sa sortie 117 la composante de l'erreur sur l'axe Q du plan complexe axe à 90° de l'axe I.

Dans le cas de l'exemple de la figure 12, pour les signaux correspondant au pilote P1 et la réception du pilote résiduel P1 r, les flèches représentent les sens des composantes et dans ce cas, les composantes donnent en sortie des tensions positives pour les composantes d'erreur sur P1, le signal P1r étant dans le premier quadrant I/Q. La tension en sortie est alors +ΔVa1 , tension qui est la somme de l'offset et de la tension d'erreur due à la partie réelle de P1 r sur la sortie 116, sortie I, et +ΔVph1, tension qui est la somme de l'offset et de la tension d'erreur due à la partie imaginaire de P1r ou au déphasage de P1r sur la sortie 117, sortie Q.

Dans le cas de l'exemple de la figure 13, pour les signaux correspondant au pilote P2, les flèches représentent les sens des composantes et dans ce cas, les composantes donnent en sortie des tensions négatives pour les composantes d'erreur sur P2.

La tension en sortie est alors +ΔVa2, tension qui est la somme de l'offset et de la tension d'erreur négative due à la partie réelle de P2r sur la sortie 116, sortie I, et +ΔVph2, tension qui est la somme de l'offset et de la tension d'erreur négative due au déphasage de P2r sur la sortie 117, sortie Q.

Pour commander les réseaux de correction de phase et d'amplitude, on fait appel à un étage de démodulation BF 114 de type multiplieur quatre quadrants comme par exemple ceux connus sous les références MC 1496 ou SA612 représenté schématiquement en figure 9 et qui comporte deux mélangeurs BF 114a, 114b, l'un recevant sur une première voie un signal issu de la sortie I 116 dudit démodulateur I/Q HF, l'autre recevant sur une première voie un signal issu de la sortie Q 117 dudit démodulateur I/Q HF, les deux mélangeurs BF 114a, 114b recevant sur leurs secondes voies le signal de découpage d généré par les moyens de commutation 113 de la figure 7.

La figure 14 représente un exemple de liaison entre une voie de sortie du démodulateur HF de type I/Q et une voie de démodulation BF.

Comme vu précédemment, en sortie 116 du démodulateur 106a on obtient un signal d'erreur comportant une composante d'offset (décalage en tension continue) due au démodulateur et une composante alternative autour de la tension d'offset dont la valeur crête à crête correspond à la somme des erreurs ΔV1, ΔV2 sur les deux pilotes P1, P2.

Le dispositif comprend des moyens d'amplification de signal 118 et des moyens d'annulation de composante continue 119 entre le démodulateur I/Q HF et les mélangeurs BF. Ces moyens sont prévus pour supprimer la tension d'offset du démodulateur HF I/Q. Pour ce faire on dispose une première capacité 119 en série entre la sortie 116 et un étage d'amplification du signal d'erreur 118 et on dispose une seconde capacité 119 entre l'étage d'amplification 118 et la première entrée 128 du mélangeur BF 114a.

Comme vu précédemment, la seconde entrée du mélangeur 114a reçoit le signal de découpage d généré par les moyens de commutation 113 de la figure 7 éventuellement recentrés autour d'une tension nulle par une capacité 129.

A partir de ces signaux alternatifs, le multiplieur quatre quadrants génère une tension continue de valeur Vem=+(ΔV1+ΔV2)/2.

Le principe est que l'on multiplie le signal de valeur crête à crête ΔV1+ΔV2 par le signal de découpage pour obtenir un signal égal à la moyenne des déviations.

Les mélangeurs BF sont ainsi adaptés à redresser les signaux d'erreur issus du démodulateur I/Q HF pour fournir une tension moyennant les erreurs sur les deux signaux pilotes P1 et P2.

La boucle d'annulation va alors chercher en continu à minimiser la somme des pilotes résiduels ΔV1+ΔV2 pour chacun des contrôles I et Q ce qui optimise l'annulation pour toute la bande depuis P1 jusqu'à P2 et l'annulation à l'aide des deux pilotes en push-pull de l'invention est comparable à un système à pilote étalé ou du système à deux pilotes et deux détections de l'art antérieur pour une complexité largement réduite..

Préférablement, pour éviter des erreurs de démodulation dans le cas où un signal de la bande utile comprendrait une fréquence identique à la fréquence du signal d de découpage, le signal de découpage d est une séquence pseudo-aléatoire dont la probabilité d'occurrence des états hauts et bas est identique.

Pour moyenner l'erreur sur l'ensemble de la bande utile, l'un des premier ou second signaux pilotes P1, P2 est généré à une fréquence inférieure ou égale à la fréquence basse de la bande de l'amplificateur, l'autre des premier et second signaux pilotes P1, P2 étant généré à une fréquence supérieure ou égale à la fréquence haute de ladite bande.

L'invention est applicable sur des amplificateurs large bande par exemple fonctionnant pour les bandes GSM, DCS et UMTS et dans les bandes du futur standard 4G soit des bandes dont la largeur peut aller jusqu'à 100MHz.

Le système de réduction de distorsion de l'invention permet ainsi à l'aide de deux pilotes, un seul réseau de correction d'amplitude et un seul réseau de correction de phase de réduire l'erreur résiduelle maximale d'un facteur 2 sur chaque réseau en la répartissant en haut et en bas de la bande de l'amplificateur.

Selon l'invention, pour réduire voir annuler la distorsion d'un amplificateur HF large bande 100 comportant un système de réduction de distorsion de l'amplificateur sur l'ensemble de la bande d'amplification par correction feedforward en utilisant un premier signal pilote P1 et un second signal pilote P2 et une boucle d'annulation 103 comportant un dispositif de correction d'erreurs basé sur les deux signaux pilotes, on règle une différence de phase proche de 0° (éventuellement modulo 360°) entre le premier signal pilote et le signal résiduel de ce premier signal pilote en sortie de l'amplificateur pour fournir un signal de référence refP1, on règle une différence de phase proche de 180° (éventuellement modulo 360°) entre le second signal pilote et le signal résiduel de ce second signal pilote en sortie de l'amplificateur pour fournir un second signal de référence refP2 et on alimente au moins un démodulateur HF 106 de pilotage de la boucle d'annulation avec les signaux de référence refP1, refP2.

Par ailleurs, pour commander la boucle d'annulation on injecte alternativement les deux signaux pilotes en entrée de l'amplificateur et on génère un signal de découpage d pour commander alternativement en correspondance un étage de démodulation BF 114 commandant des réseaux de correction de phase et d'amplitude 111, 112 de la boucle d'annulation 103.

Pour n'utiliser que deux réseaux de correction, l'un en phase, l'autre en amplitude, l'étage de démodulation BF 114 comportant deux mélangeurs BF 114a, 114b, l'un recevant sur une première voie un signal issu de la sortie I 116 dudit démodulateur I/Q HF, l'autre recevant sur une première voie un signal issu de la sortie Q 117 dudit démodulateur I/Q HF, on injecte sur la seconde voie des mélangeurs BF 114a, 114b le signal de découpage d pour moyenner les amplitudes des signaux de correction d'erreur.

On pilote alors l'unique réseau de correction d'amplitude et l'unique réseau de correction de phase à l'aide des signaux de sortie des mélangeurs BF.

De même pour réaliser une démodulation HF à l'aide d'un unique démodulateur HF 106 de type démodulateur HF I/Q on injecte sur sa première entrée 107 les premier et second signaux pilotes de référence refP1, refP2 mélangés et sur sa seconde entrée le signal de sortie de l'amplificateur au travers d'un filtre 115 adapté pour laisser passer les signaux pilotes résiduels P1 r, P2r et atténuer les fréquences S situées dans la bande de l'amplificateur.

Pour couvrir toute la bande de l'amplificateur, on génère l'un des premier ou second signaux pilotes P1, P2 à une fréquence inférieure ou égale à la fréquence basse de la bande de l'amplificateur et on génère l'autre des premier et second signaux pilotes P1, P2 à une fréquence supérieure ou égale à la fréquence haute de ladite bande.

L'invention ne se limite pas à l'exemple représenté et en comprend les variantes restant dans le cadre des revendications.

## Revendications

1. Amplificateur HF large bande (100) comportant un système de réduction de distorsion de l'amplificateur sur l'ensemble de la bande d'amplification par correction feedforward en utilisant un premier signal pilote (P1) et un second signal pilote (P2) et une boucle d'annulation (103) comportant un dispositif de correction d'erreurs basé sur les deux signaux pilotes, **caractérisé en ce que** le dispositif de correction d'erreurs comporte des premiers moyens (104) de réglage d'une différence de phase proche de 0° entre le premier signal pilote et le signal résiduel de ce premier signal pilote en sortie de l'amplificateur et des seconds moyens (105) de réglage d'une différence de phase proche de 180° entre le second signal pilote et le signal résiduel de ce second signal pilote en sortie de l'amplificateur pour alimenter au moins un démodulateur HF (106) de pilotage de la boucle d'annulation.

2. Amplificateur HF large bande selon la revendication 1, **caractérisé en ce que** les premiers moyens (104) de réglage d'une différence de phase comportent un premier moyen déphaseur disposé entre un générateur (101) du premier signal pilote (P1) et une première entrée (107) d'un démodulateur HF (106) recevant sur une seconde entrée (108) le signal résiduel (P1r) issu du premier signal pilote en sortie de l'amplificateur HF, le premier moyen déphaseur fournissant un premier signal pilote de référence (refP1) déphasé dont le déphasage compense le déphasage depuis l'entrée de l'amplificateur jusqu'à la seconde entrée du démodulateur (106).

3. Amplificateur HF large bande selon la revendication 1 **caractérisé en ce que** les second moyens (105) de réglage d'une différence de phase comportent un second moyen déphaseur disposé entre un générateur (102) du second signal pilote et une première entrée (107) d'un démodulateur HF (106) recevant sur une seconde entrée (108) le signal résiduel (P2r) issu du second signal pilote en sortie de l'amplificateur HF, le premier moyen déphaseur fournissant un second signal pilote de référence (refP2) déphasé dont le déphasage compense le déphasage depuis l'entrée de l'amplificateur jusqu'à la seconde entrée du démodulateur (106) et introduisant un déphasage supplémentaire de l'ordre de 180°.

4. Amplificateur HF large bande selon l'une des revendications 1 à 3 **caractérisé en ce qu'**il comporte des moyens de commutations (113) adaptés pour injecter alternativement les deux signaux pilotes en entrée de l'amplificateur et adaptés à générer un signal de découpage (d) pour commander alternativement en correspondance un étage de démodulation BF (114) commandant des réseaux de correction de phase et d'amplitude (111, 112) de la boucle d'annulation (103).

5. Amplificateur HF large bande selon l'une des revendications précédentes **caractérisé en ce que** la boucle d'annulation (103) comprend un unique moyen de correction de phase (111) et un unique moyen de correction d'amplitude (112).

6. Amplificateur HF selon l'une des revendications précédentes **caractérisé en ce que** la détection HF est réalisée à l'aide d'un unique démodulateur HF (106) recevant simultanément sur sa première entrée (107) les premier et second signaux pilotes de référence (refP1, refP2) et sur sa seconde entrée le signal de sortie de l'amplificateur au travers d'un filtre (115) adapté pour laisser passer les signaux pilotes résiduels (P1 r, P2r) et atténuer les fréquences (S) situées dans la bande de l'amplificateur.

7. Amplificateur HF large bande selon les revendications 5 et 6 **caractérisé en ce que** l'étage de démodulation BF (114) comporte deux mélangeurs BF (114a, 114b), l'un recevant sur une première voie un signal issu de la sortie I (116) dudit démodulateur HF, l'autre recevant sur une première voie un signal issu de la sortie Q (117) dudit démodulateur HF, les deux mélangeurs BF (114a, 114b) recevant sur leurs secondes voies le signal de découpage (d).

8. Amplificateur HF large bande selon la revendication 7 **caractérisé en ce que** les deux mélangeurs BF (114a, 114b) sont des démodulateurs ou des multiplieurs quatre quadrants.

9. Amplificateur HF large bande selon la revendication 8 **caractérisé en ce qu'**il comprend des moyens d'amplification de signal (118) et des moyens d'annulation de composante continue (119) entre le démodulateur HF et les mélangeurs BF.

10. Amplificateur HF large bande selon la revendication 7 ou 8 **caractérisé en ce que** les mélangeurs BF sont adaptés à redresser les signaux d'erreur issus du démodulateur HF pour fournir une tension (Vem) moyennant les erreurs sur les deux signaux pilotes.

11. Amplificateur HF large bande selon l'une des revendications 5 à 10 **caractérisé en ce que** le signal de découpage (d) est une séquence pseudo-aléatoire dont la probabilité d'occurrence des états hauts et bas est identique.

12. Amplificateur HF large bande selon l'une des revendications précédentes **caractérisé en ce que** l'un des premier ou second signaux pilotes (P1, P2) est généré à une fréquence inférieure ou égale à la fréquence basse de la bande de l'amplificateur, l'autre des premier et second signaux pilotes (P1, P2) étant généré à une fréquence supérieure ou égale à la fréquence haute de ladite bande.

13. Procédé de réduction de la distorsion d'un amplificateur HF large bande (100) comportant un système de réduction de distorsion de l'amplificateur sur l'ensemble de la bande d'amplification par correction feedforward en utilisant un premier signal pilote (P1) et un second signal pilote (P2) et une boucle d'annulation (103) comportant un dispositif de correction d'erreurs basé sur les deux signaux pilotes, **caractérisé en ce qu'**on règle une différence de phase proche de 0° entre le premier signal pilote et le signal résiduel de ce premier signal pilote en sortie de l'amplificateur pour fournir un signal de référence (refP1), on règle une différence de phase proche de 180° entre le second signal pilote et le signal résiduel de ce second signal pilote en sortie de l'amplificateur pour fournir un second signal de référence (refP2) et on alimente au moins un démodulateur HF (106) de pilotage de la boucle d'annulation avec les signaux de référence (refP1, refP2).

14. Procédé de réduction de la distorsion d'un amplificateur HF large bande (100) selon la revendication 13, **caractérisé en ce qu'**on injecte alternativement les deux signaux pilotes en entrée de l'amplificateur et on génère un signal de découpage (d) pour commander alternativement en correspondance un étage de démodulation BF (114) commandant des moyens de correction de phase et d'amplitude (111, 112) de la boucle d'annulation (103).

15. Procédé de réduction de la distorsion d'un amplificateur HF large bande (100) selon la revendication 14, **caractérisé en ce que**, l'étage de démodulation BF (114) comportant deux mélangeurs BF (114a, 114b), l'un recevant sur une première voie un signal issu de la sortie I (116) dudit démodulateur HF, l'autre recevant sur une première voie un signal issu de la sortie Q (117) dudit démodulateur HF, on injecte sur la seconde voie des mélangeurs BF (114a, 114b) le signal de découpage (d) pour moyenner les amplitudes des signaux de correction d'erreur.

16. Procédé de réduction de la distorsion d'un amplificateur HF large bande (100) selon la revendication 15, **caractérisé en ce qu'**on pilote un unique moyen de correction d'amplitude et un unique moyen de correction de phase à l'aide des signaux de sortie des mélangeurs BF.

17. Procédé de réduction de la distorsion d'un amplificateur HF large bande (100) selon l'une des revendications 13 à 15, **caractérisé en ce qu'**on réalise une démodulation HF à l'aide d'un unique démodulateur HF (106), on injecte sur sa première entrée (107) les premier et second signaux pilotes de référence (refP1, refP2) mélangés et sur sa seconde entrée le signal de sortie de l'amplificateur au travers d'un filtre (115) adapté pour laisser passer les signaux pilotes résiduels (P1r, P2r) et atténuer les fréquences (S) situées dans la bande de l'amplificateur.

18. 19Procédé de réduction de la distorsion d'un amplificateur HF large bande (100) selon l'une des revendications 13 à 17, **caractérisé en ce qu'**on génère l'un des premier ou second signaux pilotes (P1, P2) à une fréquence inférieure ou égale à la fréquence basse de la bande de l'amplificateur et on génère l'autre des premier et second signaux pilotes (P1, P2) à une fréquence supérieure ou égale à la fréquence haute de ladite bande.

## Claims

1. A wide-band HF amplifier (100) comprising a system for reducing distortion of the amplifier over the whole of the amplification band by feedforward correction using a first control signal (P1) and a second control signal (P2) and a cancellation loop (103) comprising an error correction device based on the two control signals, **characterised in that** the error correction device comprises first means (104) for adjusting a phase difference close to 0° between the first control signal and the residual signal of said first control signal at the output of the amplifier and second means (105) for adjusting a phase difference close to 180° between the second control signal and the residual signal of said second control signal at the output of the amplifier in order to supply at least one HF demodulator (106) controlling the cancellation loop.

2. A wide-band HF amplifier according to claim 1, **characterised in that** the first means (104) for adjusting a phase difference comprises a first phase shifting means disposed between a generator (101) of the first control signal (P1) and a first input (107) of an HF demodulator (106) receiving on a second input (108) the residual signal (P1r) issuing from the first control signal at the output of the HF amplifier, the first phase shifting means supplying a first out-of-phase reference control signal (refP1) the phase difference of which compensates for the phase difference from the input of the amplifier to the second input of the demodulator (106).

3. A wide-band HF amplifier according to claim 1, **characterised in that** the second means (105) for adjusting a phase difference comprises a second phase shifting means disposed between a generator (102) of the second control signal and a first input (107) of an HF demodulator (106) receiving at a second input (108) the residual signal (P2r) issuing from the second control signal at the output of the HF amplifier, the first phase shifting means supplying a second out-of-phase reference control signal (refP2) the phase difference of which compensates for the phase difference from the input of the amplifier to the second input of the demodulator (106) and introducing an additional phase difference of around 180°.

4. wide-band HF amplifier according to one of claims 1 to 3, **characterised in that** it comprises switching means (113) for alternately injecting the two control signals at the input of the amplifier and for generating a chopping signal (d) for alternately controlling in correspondence an LF demodulation stage (114) controlling phase and amplitude correction networks (111, 112) of the cancellation loop (103) .

5. A wide-band HF amplifier according to one of the preceding claims, **characterised in that** the cancellation loop (103) comprises a single phase-correction means (111) and a single amplitude-correction means (112).

6. An HF amplifier according to one of the preceding claims, **characterised in that** the HF detection is performed by means of a single HF demodulator (106) receiving simultaneously at its first input (107) the first and second reference control signals (refP1, refP2) and at its second input the output signal of the amplifier through a filter (115) for allowing the residual control signals (P1r, P2r) to pass and attenuating the frequencies (S) situated in the band of the amplifier.

7. A wide-band HF amplifier according to claims 5 and 6, **characterised in that** the LF demodulation stage (114) comprises two LF mixers (114a, 114b), one receiving on a first channel a signal issuing from the output 1 (116) of said HF demodulator, the other receiving on a first channel a signal issuing from the output Q (117) of said HF demodulator, the two LF mixers (114a, 114b) receiving the chopping signal (d) on their second channels.

8. A wide-band HF amplifier according to claim 7, **characterised in that** the two LF mixers (114a, 114b) are four-quadrant demodulators or multipliers.

9. A wide-band HF amplifier according to claim 8, **characterised in that** it comprises signal amplification means (118) and means (119) for cancellation of the continuous component between the HF demodulator and the LF mixers.

10. A wide-band HF amplifier according to claim 7 or 8, **characterised in that** the LF mixers are designed to rectify the error signals issuing from the HF demodulator in order to supply a voltage (Vem) averaging the errors on the two control signals.

11. A wide-band HF amplifier according to one of claims 5 to 10, **characterised in that** the chopping signal (d) is a pseudo-random sequence wherein the probability of occurrence of high and low states is identical.

12. A wide-band HF amplifier according to one of the preceding claims, **characterised in that** one of the first or second control signals (P1, P2) is generated at a frequency less or equal to the low frequency of the band of the amplifier, the other one of the first and second control signals (P1, P2) being generated at a frequency higher than or equal to the high frequency of said band.

13. A method of reducing the distortion of a wide-band HF amplifier (100), comprising a system for reducing distortion of the amplifier over the range of the amplification band by feedforward correction using a first control signal (P1) and a second control signal (P2) and a cancellation loop (103) comprising an error correction device based on the two control signals, **characterised in that** a phase difference close to 0° is adjusted between the first control signal and the residual signal of this first control signal at the output of the amplifier in order to supply a reference signal (refP1), a phase difference close to 180° is adjusted between the second control signal and the residual signal of this second control system at the output of the amplifier in order to supply a second reference signal (refP2), and at least one HF demodulator (106) controlling the cancellation loop is supplied with the reference signals (refP1, refP2).

14. A method of reducing the distortion of a wide-band HF amplifier (100) according to claim 13, **characterised in that** the two control signals are inputted alternately at the input of the amplifier and a chopping signal (d) is generated in order to control alternately in correspondence an LF demodulation stage (114) controlling means (111, 112) of correcting phase and amplitude of the cancellation loop (103).

15. A method of reducing the distortion of a wide-band HF amplifier (100) according to claim 14, **characterised in that**, the LF demodulation stage (114) comprising two LF mixers (114a, 114b), one receiving on a first channel a signal issuing from the output I (116) of said HF demodulator, the other receiving on a first channel a signal issuing from the output Q (117) of said HF demodulator, the chopping signal (d) is inputted onto the second channel of LF mixers (114a, 114b) in order to average the amplitudes of the error correction signals.

16. A method of reducing the distortion of a wide-band HF amplifier (100) according to claim 15, **characterised in that** a single amplitude-correction means and a single phase-correction means are controlled by means of the output signals of the LF mixers.

17. A method of reducing the distortion of a wide-band HF amplifier (100) according to one of claims 13 to 15, **characterised in that** an HF demodulation is carried out by means of a single HF demodulator (106), the first and second mixed reference control signals (refP1, refP2) are injected on its first input (107) and on its second input the output signal of the amplifier through a filter (115) adapted to allow the residual control signals (P1r, P2r) to pass and to attenuate the frequencies (S) situated in the band of the amplifier.

18. A method of reducing the distortion of a wide-band HF amplifier (100) according to one of claims 13 to 17, **characterised in that** one of the first or second control signals (P1, P2) is generated at a frequency less than or equal to the low frequency of the band of the amplifier and the other one of the first and second control signals (P1, P2) is generated at a frequency greater than or equal to the high frequency of said band.

## Patentansprüche

1. Breitband-HF-Verstärker (100), der ein System zum Reduzieren von Verzerrungen des Verstärkers über dem gesamten Verstärkungsband durch Vorwärtskorrektur unter Verwendung eines ersten Pilotsignals (P1) und eines zweiten Pilotsignals (P2) und eine Unterdrückungsschleife (103), die eine Vorrichtung zum Korrigieren von Fehlern anhand der zwei Pilotsignale enthält, umfasst, **dadurch gekennzeichnet, dass** die Fehlerkorrekturvorrichtung erste Mittel (104) zum Regulieren einer Phasendifferenz nahe bei 0° zwischen dem ersten Pilotsignal und dem Restsignal dieses ersten Pilotsignals am Ausgang des Verstärkers und zweite Mittel (105) zum Regulieren einer Phasendifferenz nahe bei 180° zwischen dem zweiten Pilotsignal und dem Restsignal dieses zweiten Pilotsignals am Ausgang des Verstärkers umfasst, um wenigstens einen HF-Demodulator (106) zum Ansteuern der Unterdruckungsschleife zu versorgen.

2. Breitband-HF-Verstärker nach Anspruch 1, **dadurch gekennzeichnet, dass** die ersten Phasendifferenz-Regulierungsmittel ein erstes Phasenverschiebungsmittel umfassen, das zwischen einen Generator (101) des ersten Pilotsignals (P1) und einen ersten Eingang (107) eines HF-Demodulators (106), der an einem zweiten Eingang (108) das von dem ersten Pilotsignal am Ausgang des HF-Verstärkers stammende Restsignal (P1r) empfängt, geschaltet ist, wobei das erste Phasenverschiebungsmittel ein erstes phasenverschobenes Referenz-Pilotsignal (refP1) liefert, dessen Phasenverschiebung die Phasenverschiebung von dem Eingang des Verstärkers bis zu dem zweiten Eingang des Demodulators (106) kompensiert.

3. Breitband-HF-Verstärker nach Anspruch 1, **dadurch gekennzeichnet, dass** die zweiten Phasendifferenz-Regulierungsmittel (105) ein zweites Phasenverschiebungsmittel umfassen, das zwischen einen Generator (102) des zweiten Pilotsignals und einen ersten Eingang (107) eines HF-Demodulators (106), der an einem zweiten Eingang (108) das von dem zweiten Pilotsignal am Ausgang des HF-Verstärkers stammende Restsignal (P2r) empfängt, geschaltet ist, wobei das erste Phasenverschiebungsmittel ein zweites phasenverschobenes Referenz-Pilotsignal (refP2) liefert, dessen Phasenverschiebung die Phasenverschiebung von dem Eingang des Verstärkers bis zu dem zweiten Eingang des Demodulators (106) kompensiert und eine zusätzliche Phasenverschiebung in der Größenordnung von 180° einführt.

4. Breitband-HF-Verstärker nach einem der Ansprüche 1 bis 3, **dadurch gekennzeichnet, dass** er Kommutationsmittel (113) umfasst, die dazu ausgelegt sind, die zwei Pilotsignale abwechselnd in den Eingang des Verstärkers einzugeben, und dazu ausgelegt sind, ein Zerhackungssignal (b) zu erzeugen, um abwechselnd und entsprechend eine BF-Demodulationsstufe (114) zu steuern, die Korrekturnetzwerke für die Phase und die Amplitude (111, 112) der Unterdrückungsschleife (103) steuert.

5. Breitband-HF-Verstärker nach einem der vorhergehenden Ansprüche, **dadurch gekennzeichnet, dass** die Unterdrückungsschleife (103) ein einziges Phasenkorrekturmittel (111) und ein einziges Amplitudenkorrekturmittel (112) umfasst.

6. HF-Verstärker nach einem der vorhergehenden Ansprüche, **dadurch gekennzeichnet, dass** die HF-Detektion mit Hilfe eines einzigen HF-Demodulators (106) ausgeführt wird, der gleichzeitig an seinem ersten Eingang (107) das erste und das zweite Referenz-Pilotsignal (refP1, refP2) empfängt und an seinem zweiten Eingang das Ausgangssignal des Verstärkers über ein adaptives Filter (115) empfängt, um die Rest-Pilotsignale (P1r, P2r) durchzulassen und um die Frequenzen (S), die im Band des Verstärkers liegen, zu dämpfen.

7. Breitband-HF-Verstärker nach den Ansprüchen 5 und 6, **dadurch gekennzeichnet, dass** die Demodulationsstufe BF (114) zwei BF-Mischer (114a, 114b) umfasst, wovon einer auf einem ersten Weg ein vom Ausgang (116) des HF-Demodulators stammendes Signal empfängt und der andere auf einem ersten Weg ein vom Ausgang Q (117) des HF-Demodulators stammendes Signal empfängt, wobei die zwei BF-Mischer (114a, 114b) auf ihren zweiten Wegen das Zerhackungssignal (d) empfangen.

8. Breitband-HF-Verstärker nach Anspruch 7, **dadurch gekennzeichnet, dass** die zwei BF-Mischer (114a, 114b) Demodulatoren oder 4-Quadranten-Vervielfacher sind.

9. Breitband-HF-Verstärker nach Anspruch 8, **dadurch gekennzeichnet, dass** er Signalverstärkungsmittel (118) und Gleichstromkomponenten-Unterdrückungsmittel (119) zwischen dem HF-Demodulator und den BF-Mischern umfasst.

10. Breitband-HF-Verstärker nach Anspruch 7 oder 8, **dadurch gekennzeichnet, dass** die BF-Mischer dazu ausgelegt sind, vom HF-Demodulator stammenden Fehlersignale gleichzurichten, um eine Spannung (Vem) zu liefern, die die Fehler über die zwei Pilotsignale ausmittelt.

11. Breitband-HF-Verstärker nach einem der Ansprüche 5 bis 10, **dadurch gekennzeichnet, dass** das Zerhackungssignal (d) eine Pseudozufallsfolge ist, in der die Auftrittswahrscheinlichkeit hoher und tiefer Zustände gleich ist.

12. Breitband-HF-Verstärker nach einem der vorhergehenden Ansprüche, **dadurch gekennzeichnet, dass** eines des ersten und des zweiten Pilotsignals (P1, P2) mit einer Frequenz kleiner oder gleich der unteren Frequenz des Bandes des Verstärkers erzeugt wird, während das andere des ersten und des zweiten Pilotsignals (P1, P2) mit einer Frequenz größer oder gleich der oberen Frequenz des Bandes erzeugt wird.

13. Verfahren zum Reduzieren der Verzerrung eines Breitband-HF-Verstärkers (10D), der ein System zum Reduzieren der Verzerrung des Verstärkers auf dem gesamten Verstärkungsband durch Vorwärtsregelungskorrektur unter Verwendung eines ersten Pilotsignals (P1) und eines zweiten Pilotsignals (P2) und eine Vorrichtung zum Korrigieren von Fehlern anhand der zwei Pilotsignale umfasst, **dadurch gekennzeichnet, dass** eine Phasendifferenz nahe bei 0° zwischen dem ersten Pilotsignal und dem Restsignal dieses ersten Pilotsignals am Ausgang des Verstärkers reguliert wird, um ein Referenzsignal (refP1) zu liefern, dass eine Phasendifferenz nahe bei 180° zwischen dem zweiten Pilotsignal und dem Restsignal dieses zweiten Pilotsignals am Ausgang des Verstärkers reguliert wird, um ein zweites Referenzsignal (refP2) zu liefern, und dass wenigstens ein HF-Demndulator (106) zum Ansteuern der Unterdrückungsschleife mit den Referenzsignalen (refP1, refP2) versorgt wird.

14. Verfahren zum Reduzieren der Verzerrung eines Breitband-HF-Verstärkers (10D) nach Anspruch 3, **dadurch gekennzeichnet, dass** zwei Pilotsignale abwechselnd in den Eingang des Verstärkers eingegeben werden und dass ein Zerhackungssignal (d) erzeugt wird, um abwechselnd und entsprechend eine BF-Demodulationsstufe (114) zu steuern, die Mittel zum Korrigieren der Phase und der Amplitude (111, 112) der Unterdrückungsschleife (103) steuert.

15. Verfahren zum Reduzieren der Verzerrung eines Breitband-HF-Verstärkers (100) nach Anspruch 14, **dadurch gekennzeichnet, dass** dann, wenn die BF-Demodulationsstufe (114) zwei BF-Mischer (114a, 114b) enthält, wovon einer auf einem ersten Weg ein vom Ausgang I (116) des HF-Demodulators stammendes Signal empfängt und der andere auf einem ersten Weg ein vom Ausgang Q (117) des HF-Demodulators stammendes Signal empfängt, in den zweiten Weg der BF-Mischer (114a, 114b) das Zerhackungssignal (d) eingegeben wird, um die Amplituden der Fehlerkorrektursignale auszumitteln.

16. Verfahren zum Reduzieren der Verzerrung eines Breitband-HF-Verstärkers (100) nach Anspruch 15, **dadurch gekennzeichnet, dass** ein einziges Amplitudenkorrekturmittel und ein einziges Phasenkorrekturmittel mit Hilfe der Ausgangssignale der BF-Mischer angesteuert werden.

17. Verfahren zum Reduzieren der Verzerrung eines Breitband-HF-Verstärkers (100) nach einem der Ansprüche 13 bis 15, **dadurch gekennzeichnet, dass** eine HF-Demodulation mit Hilfe eines einzigen HF-Demodulierers (106) ausgeführt wird und dass in seinen ersten Eingang (107) das erste und das zweite Referenz-Pilotsignal (refP1. refP2) eingegeben werden, die gemischt sind, und in seinen zweiten Eingang das Ausgangssignal des Verstärkers über ein adaptives Filter (115) eingegeben wird, um die Rest-Pilotsignale (P1r, P2r) durchzulassen und um die Frequenzen (S), die in dem Band des Verstärkers liegen, zu dämpfen.

18. Verfahren zum Reduzieren der Verzerrung eines Breitband-HF-Verstärkers (100) nach einem der Ansprüche 13 bis 17, **dadurch gekennzeichnet, dass** eines des ersten und des zweiten Pilotsignals (P1, P2) mit einer Frequenz kleiner oder gleich der unteren Frequenz des Bandes des Verstärkers erzeugt wird und das andere des ersten und des zweiten Pilotsignals (P1, P2) mit einer Frequenz größer oder gleich der oberen Frequenz des Bandes erzeugt wird.
